# EUROPÄISCHE PATENTSCHRIFT

(11) **EP 1 210 468 B1**
(45) Veröffentlichungstag und Bekanntmachung des Hinweises auf die Patenterteilung: **23.04.2008**
(21) Anmeldenummer: 01953989.9
(22) Anmeldetag: 21.06.2001
(51) Int. Cl.: C23C 16/44, C23C 14/56

(54) **VERFAHREN ZUM REINIGEN EINES PVD- ODER CVD-REAKTORS SOWIE VON ABGASLEITUNGEN DESSELBEN**
METHOD FOR CLEANING A PVD OR CVD REACTOR AND WASTE-GAS LINES OF THE SAME
PROCEDE POUR NETTOYER UN REACTEUR DE DEPOT PHYSIQUE EN PHASE VAPEUR OU DE DEPOT CHIMIQUE EN PHASE VAPEUR, AINSI QUE SES CONDUITES DE GAZ BRULES

(30) Priorität: 21.06.2000 DE 10029523
(43) Veröffentlichungstag der Anmeldung: 05.06.2002
(73) Patentinhaber: Air Liquide Deutschland GmbH, 40235 Düsseldorf (DE)
(72) Erfinder: DONNERHACK, Andreas, 47799 Krefeld (DE); REIMANN, Bruno, 45468 Mühlheim (DE)
(74) Vertreter: Kahlhöfer, Hermann
(86) Internationale Anmeldenummer: PCT/EP2001/006987
(87) Internationale Veröffentlichungsnummer: WO 2001/098555

(56) Entgegenhaltungen:
- EP-A- 0 874 386
- EP-A- 1 054 438
- EP-A- 1 065 295
- EP-A- 1 122 766
- WO-A-01/03858
- DE-A- 4 132 561
- US-A- 4 877 757
- US-A- 6 109 206
- US-B1- 6 189 483
- PATENT ABSTRACTS OF JAPAN vol. 010, no. 158 (E-409), 6. Juni 1986 (1986-06-06) & JP 61 014726 A (FUJITSU KK), 22. Januar 1986 (1986-01-22)

## Beschreibung

Die Erfindung betrifft ein Verfahren zum Reinigen eines PVD- oder CVD-Reaktors sowie Abgasleitungen desselben, durch Einleiten eines fluorhaltigen Behandlungsgases in den Reaktor.

Derartige Verfahren und entsprechende Vorrichtungen werden in der Halbleitertechnologie für die Abscheidung von Materialsschichten auf Substraten eingesetzt. Sie sind unter der Bezeichnung PVD- oder CVD-Reaktor allgemein bekannt, wobei die Abkürzungen PVD und CVD für "Physical Vapor Deposition" bzw. für "Chemical Vapor Deposition" stehen. Beim bestimmungsgemäßen Einsatz schlagen sich auf den Innenwandungen des Reaktors Schichten nieder, die im Verlauf des Betriebes immer dicker werden und daher vor jedem neuen Einsatz oder von Zeit zu Zeit entfernt werden müssen, um definierte Ausgangsbedingungen für eine jeweils neue Abscheidungs-Charge zu erhalten oder um ein Abplatzen und Herunterfallen der Schichten zu vermeiden. So ist beispielsweise aus der EP-A-0 874 386 ein Verfahren bekannt, bei dem ein CVD-Reaktor mit einem Plasma gereinigt wird.

Für die Reinigung haben sich Fluoratome als aktive Spezies bewährt. Die Erzeugung von Fluoratomen erfolgt bei den bekannten Reinigungsverfahren durch Dissoziation von Behandlungsgasen, die Kohlenstoff-Fluor- oder Stickstoff-Fluor-Verbindungen enthalten. Gängige Beispiele sind CF₄ und C₂F₆ bzw. NF₃.

Bei der Dissoziation dieser Verbindungen entstehen neben Fluoratomen radikalische Spezies, z.B. CF₂, C₂F₄, NF₂ oder NF, die durch chemische Reaktionen mit den Ausgangssubstanzen selbst oder mit Zwischenprodukten des Reinigungsprozesses eine Reihe von toxischen und umweltgefährdenden Produkten erzeugen, die ihrerseits aufwendig und kostspielig entsorgt werden müssen.

Der Einsatz von FKW (Fluor-Kohlenwasserstoffen) ist darüberhinaus umweltgefährdend; FKW schädigen die Ozonschicht. NF₃ ist zeitweilig auf dem Weltmarkt schlecht verfügbar und daher - wie im übrigen auch C₂F₆ - sehr teuer.

Der Erfindung liegt daher die Aufgabe zugrunde, ein kostengünstiges und effektives Verfahren anzugeben, das die genannten Nachteile des Standes der Technik vermeidet.

Hinsichtlich des Verfahrens wird diese Aufgabe ausgehend von dem eingangs genannten Verfahren erfindungsgemäß dadurch gelöst, dass molekulares Fluor enthaltendes Behandlungsgas eingesetzt und unter Bildung von atomarem Fluor einer Dissoziation unterzogen wird.

Das neue Verfahren benutzt Fluor zur Reinigung von Reaktor- und davon wegführender Abgasleitungen. Im Fall, dass im Behandlungsgas außer Fluor keine anderen aktiven Substanzen enthalten sind, werden Komplikationen hinsichtlich der Toxizität und Umweltschädlichkeit vermieden. Darüber hinaus wird der oben erwähnte Engpass bezüglich der Verfügbarkeit von NF₃ beseitigt, da Fluor in ausreichenden Mengen zur Verfügung steht.

Wesentlich ist, dass das Fluor unter Bildung von atomarem Fluor einer Dissoziation unterzogen wird. Die erzeugten Fluoratome bewirken den Reinigungsprozess im Reaktor bzw. in der Abgasleitung. Die Dissoziation von Fluormolekülen zu Fluoratomen erfolgt vorzugsweise zeitlich vor dem Einleiten des Behandlungsgases in den Reaktor. Es gibt hierfür eine Vielzahl von Möglichkeiten, wobei sich die Dissoziation durch Gasentladung anhand folgender Methoden anbietet:
- Mikrowellen (MW)
- Radiofrequenzen (RF)
- Gleichstrom (DC)
- Wechselstrom(AC)
- Induktive Kopplung (IC)
- Thermische Dissoziation
- Elektronenstoß
- Radioaktive Anregung
- Photolyse
- Radiolyse
- Heiße Atom-Reaktionen

Die Gasentladungen können entweder kontinuierlich (CW, continuous wave) oder gepulst betrieben werden. Der kontinuierliche Betrieb kann mit Gleichstrom oder mit moduliertem Gleichstrom erfolgen.

Als besonders zweckmäßig hat sich die Bildung von Fluoratomen durch Gasentladung mittels Mikrowellen, Radiowellen oder durch Erhitzen des Behandlungsgases (thermische Dissoziation) erwiesen.

Man kann unterscheiden zwischen direkter Entladung von Fluor oder Fluor - Edelgasgemischen und einer sogenannten stufenweisen Dissoziation.

Die direkte Entladung von Fluor oder Fluor - Edelgasgemischen lässt sich anhand folgender Reaktionsgleichung beschreiben:

*F*₂ → *F* + *F*

Die stufenweise Dissoziation erfolgt durch eine Reaktionssequenz mit einer Vorläufer-Substanz. Das Behandlungsgas enthält dabei erfindungsgemäß eine Vorläufer-Substanz wobei die Bildung von atomarem Fluor eine Dissoziation der Vorläufer-Substanz unter Bildung reaktiver Komponenten und anschließende chemische Reaktion der reaktiven Komponenten mit molekularem Fluor umfasst. Bei der Entladung wird zunächst die Vorläufer-Substanz in reaktive Komponenten - zum Beispiel atomare Bestandteile - dissoziiert. Stromabwärts von der Entladungszone wird molekulares Fluor eingespeist und reagiert - für das Beispiel Wasserstoff als Vorläufer-Substanz - nach folgender Sequenz:

*Dissoziation* : *H*₂ → *H* + *H*

*Reaktion* : *H* + *F*₂ → *HF* + *F*

Der hierbei entstehende Fluorwasserstoff (HF) unterstützt den Reinigungsprozess. Für die Dissoziation der Vorläufer-Substanz in Form von Wasserstoff hat sich insbesondere eine Verfahrensvariante der thermischen Dissoziation bewährt, bei der das Behandlungsgas durch Kontakt mit einer heißen, stromführenden Oberfläche erhitzt wird. Dabei wird das Behandlungsgas beispielsweise über einen hocherhitzten, stromführenden Draht aus einem hochschmelzenden Metall - wie Wolfram - geleitet. Dabei werden aus dem Metalldraht Elektronen freigesetzt, die die Dissoziation des Behandlungsgases fördern.

Hinsichtlich der Vorrichtung ist weiterhin vorteilhaft, dass eine Gasentladungs-Einrichtung zur Erzeugung einer Gasentladung in einem molekulares Fluor enthaltenden Behandlungsgases vorgesehen ist, die mit dem Reaktor fluidisch verbunden ist.

Die Vorrichtung umfasst somit im wesentlichen eine Gasentladungs-Einrichtung zur Erzeugung einer Gasentladung in einem molekulares Fluor enthaltenden Behandlungsgas und einen CVD- bzw. PVD-Reaktor.

Die Gasentladungs-Einrichtung kann innerhalb des Reaktors angeordnet sein. Vorzugsweise befindet sie sich jedoch außerhalb der Reaktors.

Als geeignet haben sich Gasentladungs-Einrichtungen erweisen, die eine Vorrichtung zur Erzeugung von Mikrowellen oder von Radiowellen oder eine Vorrichtung zum Erhitzen des Behandlungsgases umfassen. Hinsichtlich der bevorzugten Ausgestaltung der Gasentladungs-Einrichtung mit einer Vorrichtung zum Erhitzen des Behandlungsgases, die ein Bauteil mit einer aufheizbaren, stromführenden Oberfläche aufweist, wird auf die obigen näheren Erläuterungen zum erfindungsgemäßen Verfahren hingewiesen.

Nachfolgend wird die Erfindung anhand von Ausführungsbeispielen näher erläutert:

### 1. Beispiel:

Zum Entfernen von Halbleiterbeschichtungsmaterial auf der Innenwandung einer Kammer eines CVD-Reaktors wird ein Gasgemisch aus 10 bis 50 Vol-% Fluor und Argon (Rest) erzeugt und einer 13,56 MHz-RF-Entladungseinrichtung (Hersteller: Varian; Modell 98-2407) zugeführt, in der es einer kontinuierlich betriebenen Gasentladung unterzogen wird. Hierdurch bildet sich in dem Gasgemisch atomares Fluor anhand der Dissoziationsreaktion:

*F*₂ → *F* + *F*

Der Umsetzungsgrad von molekularem Fluor zu atomarem Fluor ist abhängig von Druck, Strömungsgeschwindigkeit und der konkreten Gasgemisch-Zusammensetzung; üblicherweise lieg er bei mindestens bei etwa 50 %.

Das so erzeugte Behandlungsgas enthält somit reaktives atomares Fluor, jedoch keine anderen toxischen oder umweltgefährdenden Komponenten. Das Behandlungsgas wird kontinuierlich der zu reinigenden Reaktorkammer zugeführt. Darin reagiert das atomare Fluor mit den zu beseitigenden Materialschichten ab, bis diese abgetragen sind.

### 2. Beispiel:

Zum Entfernen von Halbleiterbeschichtungsmaterial auf der Innenwandung einer Kammer eines PVD-Reaktors wird ein Behandlungsgas in den Reaktor eingeleitet, das atomares Fluor und Fluorwasserstoff enthält. Dieses Behandlungsgas wird durch eine sogenannte stufenweise Dissoziation erhalten, wobei zunächst Wasserstoff (100 Vol.-% H₂) thermisch dissoziiert wird. Hierzu wird ein Wasserstoffgasstrom über die glühende Oberfläche eines stromdurchflossenen Wolframdrahtes geleitet. Durch den Kontakt mit der heißen, stromführenden Wo-Oberfläche erfolgt eine thermische Zersetzung der Wasserstoffmoleküle in Wasserstoffatome, wobei die Dissozitaion durch die aus dem Metalldraht freigesetzten Elektronen gefördert wird. Der Dissoziationsgrad liegt bei etwa 10 %. Dem so hergestellten reaktiven Gas wird anschließend ein weiterer Gasstrom zugeführt, der ca. 50 Vol.-% molekulares Fluor enthält; der Rest ist Argon. Die Flussraten der beiden Gasströme wird so eingestellt, dass das Molverhältnis [H] / [F₂] zwischen 1 und 10 liegt. Das molekulare Fluor reagiert mit den reaktiven Wasserstoffatomen unter Bildung von HF. Die bei der stufenweisen Dissoziation ablaufenden chemischen Reaktionen lassen sich wie folgt beschreiben:

*Dissoziation* : *H*₂ → *H* + *H*

*Reaktion* : *H* + *F*₂ → *HF* + *F*

Das so erzeugte, atomares Fluor enthaltende Behandlungsgas wird kontinuierlich der Reaktorkammer zugeführt. Der im Behandlungsgas zusätzlich enthaltene Fluorwasserstoff (HF) unterstützt dabei den Reinigungsprozess.

## Patentansprüche

1. Verfahren zum Reinigen eines PVD- oder CVD-Reaktors sowie von dem Reaktor wegführender Abgasleitungen durch Einleiten eines fluorhaltigen Behandlungsgases in den Reaktor, bei dem molekulares Fluor enthaltendes Behandlungsgas eingesetzt und unter Bildung von atomarem Fluor einer Dissoziation unterzogen wird, **dadurch gekennzeichnet, dass** das Behandlungsgas eine Vorläufer-Substanz enthält, und dass die Bildung von atomarem Fluor eine Dissoziation der Vorläufer-Substanz unter Bildung reaktiver Komponenten und anschließende chemische Reaktion der reaktiven Komponenten mit molekularem Fluor umfasst, wobei als Vorläufer-Substanz molekularer Wasserstoff eingesetzt wird.

2. Verfahren nach Anspruch 1, **dadurch gekennzeichnet, dass** die Dissoziation zeitlich vor dem Einleiten des Behandlungsgases in den Reaktor erfolgt.

3. Verfahren nach Anspruch 1 oder 2, **dadurch gekennzeichnet, dass** die Dissoziation durch Gasentladung bewirkt wird.

4. Verfahren nach Anspruch 3, **dadurch gekennzeichnet, dass** die Gasentladung durch Mikrowellen, Radiowellen oder durch Erhitzen des Behandlungsgases bewirkt wird.

5. Verfahren nach Anspruch 4, **dadurch gekennzeichnet, dass** das Behandlungsgas durch Kontakt mit einer heißen, stromführenden Oberfläche erhitzt wird.

6. Verfahren nach einem der Ansprüche 1 bis 5, **dadurch gekennzeichnet, dass** der Wasserstoff thermisch dissoziiert wird.

## Claims

1. Method of cleaning a PVD or CVD reactor and also offgas lines leading from the reactor by introducing a fluorine-containing treatment gas into the reactor, in which treatment gas containing molecular fluorine is used and subjected to dissociation to form atomic fluorine, **characterized in that** the treatment gas contains a precursor substance and **in that** the formation of atomic fluorine comprises dissociation of the precursor substance to form reactive components and subsequent chemical reaction of the reactive components with molecular fluorine, with molecular hydrogen being used as precursor substance.

2. Method according to Claim 1, **characterized in that** the dissociation occurs at a time before the treatment gas is introduced into the reactor.

3. Method according to Claim 1 or 2, **characterized in that** the dissociation is effected by means of a gas discharge.

4. Method according to Claim 3, **characterized in that** the gas discharge is brought about by means of microwaves, radio waves or by heating of the treatment gas.

5. Method according to Claim 4, **characterized in that** the treatment gas is heated by contact with a hot, current-conducting surface.

6. Method according to any of Claims 1 to 5, **characterized in that** the hydrogen is dissociated thermally.

## Revendications

1. Procédé de nettoyage d'un réacteur de PVD ou de CVD et des conduits d'évacuation de gaz qui sortent du réacteur par introduction dans le réacteur d'un gaz fluoré de traitement, dans lequel on utilise un gaz de traitement qui contient du fluor moléculaire et on lui fait subir une dissociation de formation de fluor atomique, **caractérisé en ce que** le gaz de traitement contient une substance de précurseur et **en ce que** la formation de fluor atomique comprend une dissociation de la substance de précurseur avec formation de composants réactifs et ensuite une réaction chimique des composants réactifs avec le fluor moléculaire et **en ce qu'**on utilise comme substance de précurseur de l'hydrogène moléculaire.

2. Procédé selon la revendication 1, **caractérisé en ce que** la dissociation s'effectue avant l'introduction du gaz de traitement dans le réacteur.

3. Procédé selon les revendications 1 ou 2, **caractérisé en ce que** la dissociation est obtenue par décharge dans le gaz.

4. Procédé selon la revendication 3, **caractérisé en ce que** la décharge dans le gaz est obtenue par micro-ondes, ondes radio ou par chauffage du gaz de traitement.

5. Procédé selon la revendication 4, **caractérisé en ce que** le gaz de traitement est chauffé par contact avec une surface chaude électriquement conductrice.

6. Procédé selon l'une des revendications 1 à 5, **caractérisé en ce que** l'hydrogène est dissocié thermiquement.
